(19) **Europäisches Patentamt**
**European Patent Office**
**Office européen des brevets**

(11) **EP 4 270 544 A1**

(12) **EUROPEAN PATENT APPLICATION**
published in accordance with Art. 153(4) EPC

(43) Date of publication:
**01.11.2023 Bulletin 2023/44**

(21) Application number: **21938954.1**

(22) Date of filing: **12.11.2021**

(51) International Patent Classification (IPC):
$H01M\ 4/505$ (2010.01)  $H01M\ 4/525$ (2010.01)
$H01M\ 10/0525$ (2010.01)  $C01G\ 53/00$ (2006.01)
$C30B\ 1/10$ (2006.01)  $C30B\ 29/22$ (2006.01)

(52) Cooperative Patent Classification (CPC):
Y02E 60/10

(86) International application number:
**PCT/CN2021/130208**

(87) International publication number:
**WO 2022/227494 (03.11.2022 Gazette 2022/44)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **28.04.2021 CN 202110463007**

(71) Applicant: **SVOLT ENERGY TECHNOLOGY CO.,
LTD**
**Changzhou, Jiangsu 213200 (CN)**

(72) Inventors:
• **MA, Jiali**
**hangzhou, Jiangsu 213200 (CN)**

• **ZHANG, Shutao**
**hangzhou, Jiangsu 213200 (CN)**
• **LI, Zitan**
**hangzhou, Jiangsu 213200 (CN)**
• **WANG, Zhuang**
**hangzhou, Jiangsu 213200 (CN)**
• **WANG, Yazhou**
**hangzhou, Jiangsu 213200 (CN)**
• **BAI, Yan**
**hangzhou, Jiangsu 213200 (CN)**
• **PAN, Hailong**
**hangzhou, Jiangsu 213200 (CN)**

(74) Representative: **De Bonis, Paolo**
**Buzzi, Notaro & Antonielli d'Oulx S.p.A.**
**Corso Vittorio Emanuele II, 6**
**10123 Torino (IT)**

(54) **SINGLE-CRYSTAL HIGH-NICKEL POSITIVE ELECTRODE MATERIAL AND PREPARATION METHOD THEREFOR AND APPLICATION THEREOF**

(57) The present invention provides a single-crystal high-nickel positive electrode material and a preparation method therefor and an application thereof. The preparation method comprises the following steps: (1) mixing a precursor, a lithium source, and a nano oxide, and performing primary sintering treatment in an oxygen-containing atmosphere to obtain a primary sintered material; and (2) mixing the primary sintered material obtained in step (1) with a titanium source and a cobalt source, and performing secondary sintering treatment in an oxygen-containing atmosphere to obtain the single-crystal high-nickel positive electrode material. The present invention uses a Ti/Co co-coating method, the residual alkali amount of the prepared single-crystal high-nickel positive electrode material can be greatly reduced, and the capacity and the rate capability can also be kept at a high level, so that the technological process is reduced, and the cost is reduced.

FIG. 1

**Description**

TECHNICAL FIELD

The present disclosure relates to the field of lithium-ion batteries, for example, to a single-crystal high-nickel positive electrode material and a preparation method thereof and an application thereof.

BACKGROUND

For synthesizing high nickel ternary lithium nickel cobalt manganese oxide (NCM) positive electrode material or lithium nickel cobalt aluminum oxide (NCA) positive electrode material, if the residual alkali content on the surface of the material is high, the material will be easy to absorb water. On the one hand, the subsequent coating of the positive electrode material will be difficult, and at the same time, higher requirements are put forward for the electrolyte in terms of alkali resistance, high alkalinity will cause the battery to generate gas and swell during the cycle, further affecting the cycle performance of the battery. On the other hand, in the charged state, because $Ni^{4+}$ exists on the surface of positive electrode material particles, which has high activity and is easy to have side reactions with electrolyte, the impedance of the battery will increase and irreversible capacity loss will occur.

At present, the most common solutions to the above problems are washing, coating and complex structural design of positive electrode materials to improve the cycle performance and rate capability of materials, but the improvement results are not ideal.

SUMMARY

The present disclosure provides a single-crystal high-nickel positive electrode material and a preparation method thereof and an application thereof. By adopting a Ti/Co co-coating method, the residual alkali content of the prepared single-crystal high-nickel positive electrode material can be greatly reduced, and meanwhile, the capacity and rate capability are also kept at a high level, thereby simplifying the technological process and reducing the cost.

In one embodiment, the present disclosure provides a preparation method of a single-crystal high-nickel positive electrode material, which comprises the following steps:

(1) mixing a precursor, a lithium source and a nano-oxide, and performing primary sintering treatment in an oxygen-containing atmosphere to obtain a primary sintered material; and

(2) mixing the primary sintered material obtained in step (1) with a titanium source and a cobalt source, and performing secondary sintering treatment in an oxygen-containing atmosphere to obtain the single-crystal high-nickel positive electrode material.

In the present disclosure, the nano-oxide is doped in the precursor and the lithium source, which can reduce the lithium-nickel mixing, stabilize the crystal structure, improve the conductivity of electrode materials, and further improve the safety and long-term cycle stability of the battery. In the present disclosure, the Ti/Co co-coating method is adopted, which can greatly reduce the residual alkali content of the prepared single-crystal high-nickel positive electrode material, and at the same time, the capacity and rate capability are kept at a high level, thus simplifying the technological process and reducing the cost.

In one embodiment, the precursor in step (1) includes $Ni_xCo_yMn_z(OH)_2$, where $x \geq 0.8$, for example, x is 0.8, 0.82, 0.85 or 0.88, etc., $0.2 \geq y \geq 0$, for example, y is 0, 0.05, 0.1, 0.15 or 0.2, etc., and $0.2 \geq z \geq 0$, for example, z is 0, 0.05, 0.1, 0.15 or 0.2, etc., and x+y+z=1.

In one embodiment, the lithium source in step (1) comprises lithium hydroxide and/or lithium carbonate.

In one embodiment, the nano-oxide in step (1) comprises any one or a combination of at least two of zirconium oxide, titanium oxide, tungsten oxide, molybdenum oxide, aluminum oxide or yttrium oxide.

A molar ratio of lithium in the lithium source to nickel, cobalt and manganese metals in the precursor in step (1) is 1:(1-1.1), for example, 1:1, 1:1.02, 1:1.05, 1:1.08 or 1:1.1.

In one embodiment, the nano-oxide accounts for 0.05%-0.3% of the single-crystal high-nickel positive electrode material by mass, for example, 0.05%, 0.08%, 0.1%, 0.2% or 0.3%, etc.

In one embodiment, a speed of the mixing in step (1) is 500-3000 rpm, for example, 500 rpm, 800 rpm, 1000 rpm, 2000 rpm or 3000 rpm, etc.

In one embodiment, a time of the mixing in step (1) is 10-30 min, for example, 10 min, 12 min, 15 min, 20 min, 25 min or 30 min, etc.

In one embodiment, a flow rate of the oxygen in step (1) is 5-20 L/min, for example, 5 L/min, 10 L/min, 12 L/min, 15 L/min or 20 L/min, etc.

In one embodiment, a temperature of the primary sintering treatment in step (1) is 800-950°C, for example, 800°C, 850°C, 900°C or 950°C, etc.

In one embodiment, a heating rate of the primary sintering treatment in step (1) is 2-5°C/min, for example, 2°C/min, 3°C/min, 4°C/min or 5°C/min, etc.

In one embodiment, a time of the primary sintering treatment in step (1) is 5-15 h, for example, 5 h, 8 h, 10 h, 12 h or 15 h, etc.

In one embodiment, after the primary sintering treatment in step (1), the primary sintered material is crushed, pulverized and screened.

In one embodiment, an aperture of the screen is 300-400 mesh, for example, 300 mesh, 320 mesh, 350 mesh, 380 mesh or 400 mesh, etc.

In one embodiment, the titanium source in step (2) comprises any one or a combination of at least two of titanium oxide, titanium hydroxide or titanium sulfate.

In one embodiment, the cobalt source in step (2) comprises any one or a combination of at least two of cobaltosic oxide, cobalt chloride, cobalt acetate, cobalt nitrate, cobalt hydroxide or cobalt sulfate.

In one embodiment, a mass ratio of the primary sintered material, the titanium source and the cobalt source is 1:(0.001-0.006):(0.001-0.015), for example, 1:0.001:0.001, 1:0.003:0.002, 1: 0.005: 0.01, 1:0.005:0.012 or 1:0.006:0.015, etc.

In one embodiment, a speed of the mixing in step (2) is 800-2000 rpm, for example, 800 rpm, 1000 rpm, 1200 rpm, 1500 rpm or 2000 rpm, etc.

In one embodiment, a time of the mixing in step (2) is 10-30 min, for example, 10 min, 12 min, 15 min, 20 min, 25 min or 30 min, etc.

In one embodiment, a flow rate of the oxygen in step (2) is 5-20 L/min, for example, 5 L/min, 10 L/min, 12 L/min, 15 L/min or 20 L/min, etc.

In one embodiment, a temperature of the secondary sintering treatment in step (2) is 500-850°C, for example, 500°C, 650°C, 700°C or 950°C, etc.

In one embodiment, a heating rate of the secondary sintering treatment in step (2) is 2-5°C/min, for example, 2°C/min, 3°C/min, 4°C/min or 5°C/min, etc.

In one embodiment, a time of the secondary sintering treatment in step (2) is 4-20 h, for example, 4 h, 8 h, 10 h, 15 h or 20 h, etc.

In one embodiment, after the secondary sintering treatment in step (2), the single-crystal high-nickel positive electrode material is crushed and screened.

In one embodiment, an aperture of the screen is 300-400 mesh, for example, 300 mesh, 320 mesh, 350 mesh, 380 mesh or 400 mesh, etc.

In one embodiment, the present disclosure provides a single-crystal high-nickel positive electrode material, which is prepared by the aforementioned method.

In one embodiment, the present disclosure provides a positive electrode sheet, which comprises the single-crystal high-nickel positive electrode material.

In one embodiment, a specific surface area of the single-crystal high-nickel positive electrode material is 0.5-0.8 $m^2$/g, for example, 0.5 $m^2$/g, 0.6 $m^2$/g, 0.7 $m^2$/g or 0.8 $m^2$/g, etc.

In one embodiment, a pH of the single-crystal high-nickel positive electrode material is less than or equal to 11.8, for example, 10, 10.2, 10.8, 11, 11.5 or 11.8, etc.

In one embodiment, a residual alkali of the single-crystal high-nickel positive electrode material is less than or equal to 3500 ppm, for example, 3000 ppm, 3100 ppm, 3200 ppm, 3300 ppm, 3400 ppm or 3500 ppm, etc.

In one embodiment, the present disclosure provides a lithium-ion battery, which comprises the positive electrode sheet.

BRIEF DESCRIPTION OF DRAWINGS

The accompanying drawings are used to provide a further understanding of the technical scheme herein, and constitute a part of the specification, and together with the embodiments of the present application, serve to explain the technical scheme herein, and do not constitute a limitation on the technical scheme herein.

FIG. 1 is an SEM image of the single-crystal high-nickel positive electrode material in one embodiment of the present disclosure.

FIG. 2 is a curve of the single-crystal high-nickel positive electrode material at 3.0-4.3 V for 50 cycles in one embodiment of the present disclosure.

DETAILED DESCRIPTION

In one embodiment, the present disclosure provides a preparation method of a single-crystal high-nickel positive electrode material, which comprises the following steps:

(1) a precursor, a lithium source and a nano-oxide are mixed, and subjected to primary sintering treatment in an oxygen-containing atmosphere to obtain a primary sintered material; and

(2) the primary sintered material obtained in step (1) is mixed with a titanium source and a cobalt source, and subjected to secondary sintering treatment in an oxygen-containing atmosphere to obtain the single-crystal high-nickel positive electrode material.

In the present disclosure, the nano-oxide is doped in the precursor and the lithium source, which can reduce the lithium-nickel mixing, stabilize the crystal structure, improve the conductivity of electrode materials, and further improve the safety and long-term cycle stability of the battery. In the present disclosure, Ti/Co co-coating method is adopted, which can greatly reduce the residual alkali content of the prepared single-crystal high-nickel positive electrode material, and at the same time, the capacity and rate capability are kept at a high level, thus simplifying the technological process and reducing the cost.

In one embodiment, the precursor in step (1) includes $Ni_xCo_yMn_z(OH)_2$, wherein $x \geq 0.8$, for example, x is 0.8, 0.82, 0.85 or 0.88, etc., $0.2 \geq y \geq 0$, for example, y is 0, 0.05, 0.1, 0.15 or 0.2, etc., and $0.2 \geq z \geq 0$, for example, z is 0, 0.05, 0.1, 0.15 or 0.2, etc., and x+y+z=1.

In one embodiment, the lithium source in step (1) comprises lithium hydroxide and/or lithium carbonate.

In one embodiment, the nano-oxide in step (1) comprises any one or a combination of at least two of zirconium oxide, titanium oxide, tungsten oxide, molybdenum oxide, aluminum oxide or yttrium oxide.

A molar ratio of lithium in the lithium source to nickel, cobalt and manganese metals in the precursor in step (1) is 1:(1-1.1), for example, 1:1, 1:1.02, 1:1.05, 1:1.08 or 1:1.1.

In one embodiment, the nano-oxide accounts for 0.05%-0.3% of the single-crystal high-nickel positive electrode material by mass, for example, 0.05%, 0.08%, 0.1%, 0.2% or 0.3%, etc.

In one embodiment, a speed of the mixing in step (1) is 500-3000 rpm, for example, 500 rpm, 800 rpm, 1000 rpm, 2000 rpm or 3000 rpm, etc.

In one embodiment, a time of the mixing in step (1) is 10-30 min, for example, 10 min, 12 min, 15 min, 20 min, 25 min or 30 min, etc.

In one embodiment, a flow rate of the oxygen in step (1) is 5-20 L/min, for example, 5 L/min, 10 L/min, 12 L/min, 15 L/min or 20 L/min, etc.

In one embodiment, a temperature of the primary sintering treatment in step (1) is 800-950°C, for example, 800°C, 850°C, 900°C or 950°C, etc.

The sintering temperature in step (1) of the present disclosure will affect the residual alkali content of the prepared single-crystal high-nickel positive electrode material. If the sintering temperature is controlled at 800-950°C, the single-crystal high-nickel positive electrode material with low residual alkali content can be prepared. If the temperature is lower than 800°C, on the one hand, the residual alkali content of the material will increase, on the other hand, the primary particles will be too small, which will affect the cycle stability of the material. If the temperature is higher than 950igher thaet th particles of the material will be too large, the capacity will decrease accordingly.

In one embodiment, a heating rate of the primary sintering treatment in step (1) is 2-5°C/min, for example, 2°C/min, 3°C/min, 4°C/min or 5°C/min, etc.

In one embodiment, a time of the primary sintering treatment in step (1) is 5-15 h, for example, 5 h, 8 h, 10 h, 12 h or 15 h, etc.

In one embodiment, after the primary sintering treatment in step (1), the primary sintered material is crushed, pulverized and screened.

In one embodiment, an aperture of the screen is 300-400 mesh, for example, 300 mesh, 320 mesh, 350 mesh, 380 mesh or 400 mesh, etc.

In one embodiment, the titanium source in step (2) comprises any one or a combination of at least two of titanium oxide, titanium hydroxide or titanium sulfate.

In one embodiment, the cobalt source in step (2) comprises any one or a combination of at least two of cobaltosic oxide, cobalt chloride, cobalt acetate, cobalt nitrate, cobalt hydroxide or cobalt sulfate.

In one embodiment, a mass ratio of the primary sintered material, the titanium source and the cobalt source is 1:(0.001-0.006):(0.001-0.015), for example, 1:0.001:0.001, 1:0.003:0.002, 1:0.005:0.01, 1:0.005:0.012 or 1:0.006:0.015, etc.

The mass ratio of the primary sintered material, the titanium source and the cobalt source in the present disclosure can affect the residual alkali content of the prepared single-crystal high-nickel positive electrode material. Controlling the mass ratio of the primary sintered material, the titanium source and the cobalt source at 1:(0.001-0.006):(0.001-0.015) will prepare the single-crystal high-nickel positive electrode material with low residual alkali content.

In one embodiment, a speed of the mixing in step (2) is 800-2000 rpm, for example, 800 rpm, 1000 rpm, 1200 rpm, 1500 rpm or 2000 rpm, etc.

In one embodiment, a time of the mixing in step (2) is 10-30 min, for example, 10 min, 12 min, 15 min, 20 min, 25 min or 30 min, etc.

In one embodiment, a flow rate of the oxygen in step (2) is 5-20 L/min, for example, 5 L/min, 10 L/min, 12 L/min, 15 L/min or 20 L/min, etc.

In one embodiment, a temperature of the secondary sintering treatment in step (2) is 500-850°C, for example, 500°C, 650°C, 700°C or 950°C.

The sintering temperature in step (2) of the present disclosure will affect the residual alkali content of the prepared single-crystal high-nickel positive electrode material. By controlling the sintering temperature at 500-850°C, the single-crystal high-nickel positive electrode material with low residual alkali content can be prepared. If the temperature is lower than 500°C, the combination between the coating layer and the primary sintered base material will be unfirm, resulting in the partial peeling of the coating during the cycle, increasing the contact area between the electrolyte and the positive electrode material, increasing the side reaction, and resulting in gas generation of the battery and poor cycle performance; if the temperature is higher than 850°C, the primary particles will be hard agglomerates and caking, and difficult to be screened directly, requiring the crushing process to break the agglomerates; at the same time, the high temperature will also make the primary particle size larger and affect the material capacity.

In one embodiment, a heating rate of the secondary sintering treatment in step (2) is 2-5°C/min, for example, 2°C/min, 3°C/min, 4°C/min or 5°C/min, etc.

In one embodiment, a time of the secondary sintering treatment in step (2) is 4-20 h, for example, 4 h, 8 h, 10 h, 15 h or 20 h, etc.

In one embodiment, after the secondary sintering treatment in step (2), the single-crystal high-nickel positive electrode material is crushed and screened.

In one embodiment, an aperture of the screen is 300-400 mesh, for example, 300 mesh, 320 mesh, 350 mesh, 380 mesh or 400 mesh, etc.

In one embodiment, the present disclosure provides a single-crystal high-nickel positive electrode material, which is prepared by the aforementioned method.

In one embodiment, the present disclosure provides a positive electrode sheet, which comprises the single-crystal high-nickel positive electrode material.

In one embodiment, a specific surface area of the single-crystal high-nickel positive electrode material is 0.5-0.8 $m^2/g$, for example, 0.5 $m^2/g$, 0.6 $m^2/g$, 0.7 $m^2/g$ or 0.8$m^2/g$, etc.

In one embodiment, a pH of the single-crystal high-nickel positive electrode material is less than or equal to 11.8, for example, 10, 10.2, 10.8, 11, 11.5 or 11.8, etc.

In one embodiment, a residual alkali of the single-crystal high-nickel positive electrode material is less than or equal to 3500 ppm, for example, 3000 ppm, 3100 ppm, 3200 ppm, 3300 ppm, 3400 ppm or 3500 ppm, etc.

In one embodiment, the present disclosure provides a lithium-ion battery, which comprises the positive electrode sheet.

Example 1

This example provides a single-crystal high-nickel positive electrode material, which specifically includes:

(1) $Ni_{0.83}Co_{0.11}Mn_{0.06}(OH)_2$ and lithium hydroxide were weighed according to a lithium/metal ratio of 1.03:1 and added into high-speed mixing equipment, and then 0.1% of nano-zirconium oxide was added, mixed at 1000 rpm for 20 min, heated to 850°C at an oxygen flow rate of 10 L/min and a heating rate of 3°C/min, sintered for 10 h, and cooled to room temperature and crushed and then screened with a 300-mesh screen to obtain a primary sintered material; and

(2) the primary sintered material obtained in the step (1) was mixed with titanium oxide and cobaltosic oxide according to a mass ratio of 1:0.003:0.008, heated to 800°C at an oxygen flow rate of 10 L/min and a heating rate of 3°C/min and sintered for 15 hours, cooled to room temperature, crushed, and then screened with a 300-mesh screen to obtain the single-crystal high-nickel positive electrode material.

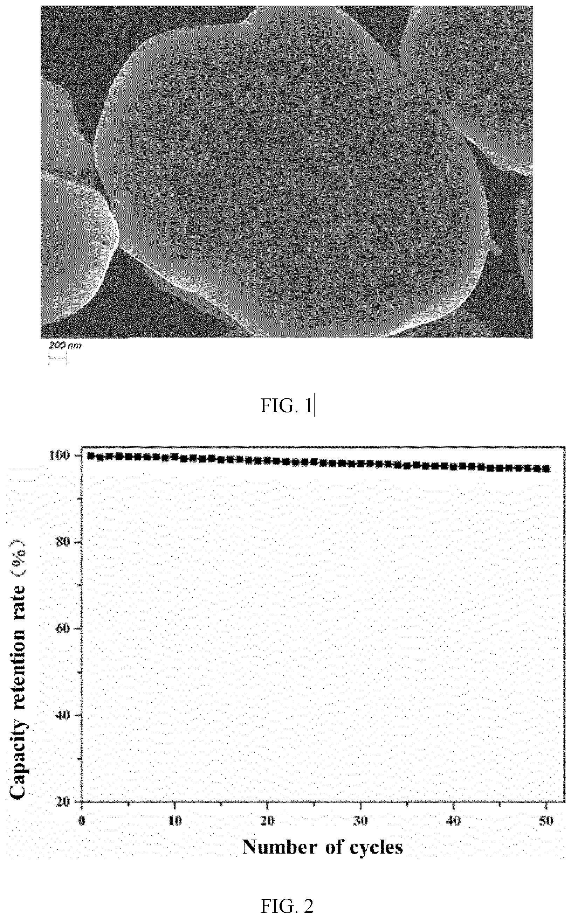

The SEM image of the single-crystal high-nickel positive electrode material is shown in FIG. 1, and it can be seen from FIG. 1 that the single-crystal particles of the single-crystal high-nickel positive electrode material prepared by the method in the present disclosure has uniform surface coating.

The curve of the single-crystal high-nickel positive electrode material at 3.0-4.3V for 50 cycles is shown in FIG 2.

Example 2

This example provides a single-crystal high-nickel positive electrode material, which specifically includes:

(1) $Ni_{0.8}Co_{0.1}Mn_{0.1}(OH)_2$ and lithium hydroxide were weighed according to a lithium/metal ratio of 1:1 and added into high-speed mixing equipment, and then 0.15% nano-tungsten oxide was added, mixed at 1500 rpm for 20 min, heated to 900°C at an oxygen flow rate of 12 L/min and a heating rate of 4°C/min, sintered for 8 hours, cooled to room temperature and crushed and then screened with a 400-mesh screen to obtain a primary sintered material; and

(2) the primary sintered material obtained in step (1) was mixed with titanium hydroxide and cobalt chloride according to a mass ratio of 1:0.005:0.012, heated to 750°C at an oxygen flow rate of 12 L/min and a heating rate of 4°C/min and sintered for 12 hours, cooled to room temperature, crushed, and then screened with a 400-mesh screen to obtain the single-crystal high-nickel positive electrode material.

Example 3

The difference between this example and Example 1 was that the sintering temperature in step (1) was 800°C.

Example 4

The difference between this example and Example 1 was that the sintering temperature in step (1) was 950°C.

Example 5

The difference between this example and Example 1 was that the sintering temperature in step (2) was 500°C.

Example 6

The difference between this example and Example 1 was that the sintering temperature in step (2) was 850°C.

Example 7

The difference between this example and Example 1 was that the mass ratio of the primary sintered material and titanium oxide in step (2) was 1:0.001.

Example 8

The difference between this example and Example 1 was that the mass ratio of the primary sintered material and titanium oxide in step (2) was 1:0.006.

Example 9

The difference between this example and Example 1 was that the mass ratio of the primary sintered material and cobaltosic oxide in step (2) was 1:0.001.

Example 10

The difference between this example and Example 1 was that the mass ratio of the primary sintered material and cobaltosic oxide in step (2) was 1:0.015.

Comparative Example 1

The difference between this comparative example and Example 1 was that titanium oxide was not added.

Comparative Example 2

The difference between this comparative example and Example 1 was that cobaltosic oxide was not added.

Comparative Example 3

The difference between this comparative example and Example 1 was that cobaltosic oxide and titanium oxide were not added.

The single-crystal high-nickel positive electrode materials prepared in Examples 1 to 10 and Comparative Examples 1 to 3 were evaluated.

1. Residual alkali detection steps:

(1) sample treatment: 10 g of sample was weighed into a 250 mL dry beaker, 100 mL of pure water was added, a magnetic stirring bar was added into the beaker and the beaker was covered with a plastic wrap, the system was stirred for 30 min with a magnetic stirrer, and then allowed to stand for 2 min after stirring, a clean funnel was put into a clean conical bottle, a circular filter paper was fold in half and put into the funnel for filtering, and the conical bottle was covered with a rubber plug after filtering;

(2) the detection method was selected as needed, and loaded by clicking;

(3) 50 mL of solution was transferred into a titration cup with a pipette (which can be adjusted according to the actual situation), the sample mass was inputted into the potentiometric titrator software, 100 mL of ultrapure water was added for dilution, and the detection was started by pressing the starting button;

(4) when there were two obvious titration inflection points in the detection process, it was considered that the titration end point had been reached, and the detection was ended by pressing the end button, and the two inflection points were $V_1$ and $V_2$ respectively;

(5) calculation

calculation of lithium carbonate content:

$$X_2 = c * （V_2 - V_1） * 73.89 * 2/1000/m * 100\%$$

Vi- the volume of standard solution used to titrate the sample until reaching the first obvious inflection point, in milliliter (mL);

$V_2$- the volume of standard solution used to titrate the sample until reaching the second obvious inflection point, in milliliter (mL);

c- standard concentration of hydrochloric acid, c(HCl) = 0.05 mol/L, according to GB/T601; ;

calculation of lithium hydroxide content:

$$X_3 = c * （2V_1 - V_2） * 23.95 * 2/1000/m * 100\%$$

wherein 23.95 g/mol is the molar mass of lithium hydroxide;

73.98 g/mol is the molar mass of lithium carbonate.

m is the sample mass in g, and the test results are shown in Table 1.

Table 1

| | Residual alkali content (ppm) | | |
|---|---|---|---|
| | LiOH | $Li_2CO_3$ | Total residual alkali content |
| Example 1 | 1500 | 1000 | 2500 |
| Example 2 | 1840 | 700 | 2540 |
| Example 3 | 2120 | 1250 | 3370 |
| Example 4 | 1900 | 1100 | 3000 |
| Example 5 | 2280 | 1150 | 3430 |
| Example 6 | 2070 | 1010 | 3080 |

(continued)

| | Residual alkali content (ppm) | | |
|---|---|---|---|
| | LiOH | $Li_2CO_3$ | Total residual alkali content |
| Example 7 | 1880 | 1050 | 2930 |
| Example 8 | 1950 | 1340 | 3290 |
| Example 9 | 2160 | 1310 | 3470 |
| Example 10 | 1650 | 1200 | 2850 |
| Comparative Example 1 | 2320 | 9800 | 12120 |
| Comparative Example 2 | 2400 | 10050 | 12450 |
| Comparative Example 3 | 2500 | 10900 | 13400 |

As shown in Table 1, from the comparison between Example 1 and Examples 3-4, it can be seen that the sintering temperature in step (1) can affect the residual alkali content of the prepared single-crystal high-nickel positive electrode material, and the single-crystal high-nickel positive electrode material with low residual alkali content can be prepared by controlling the sintering temperature at 800-950°C, if the temperature is lower than 800°C, on the one hand, the residual alkali content of the material will increase, on the other hand, the primary particles will be small, which affects the cyclic stability of the material, and if the temperature is higher than 950°C, the primary particles of the material will be larger, and the capacity will decrease accordingly.

From the comparison between Example 1 and Examples 5-6, it can be seen that the sintering temperature in step (2) will affect the residual alkali content of the prepared single-crystal high-nickel positive electrode material, and the single-crystal high-nickel positive electrode material with low residual alkali content can be prepared by controlling the sintering temperature at 500-850°C. If the temperature is lower than 500°C, the coating cannot be firmly combined with the primary sintered base material, resulting in the partial peeling of the coating during the cycling process, and the contact area between the electrolyte and the positive electrode material will increase, the side reactions will increase, the battery will generate gas and swell and the cycle performance will become worse; if the secondary sintering temperature is higher than 850°C, the primary particles will be hard agglomerates and caking, and difficult to be screened directly, requiring the crushing process to break the agglomerates; at the same time, the high temperature will also make the primary particle size larger and affect the material capacity.

From the comparison between Example 1 and Examples 7-10, it can be seen that the mass ratio of the primary sintered material, the titanium source and the cobalt source mentioned in step (2) will affect the residual alkali content of the prepared single-crystal high-nickel positive electrode material. Controlling the mass ratio of the primary sintered material, the titanium source and the cobalt source at 1:(0.001-0.006):(0.001-0.015) will produce single-crystal high-nickel with low residual alkali.

The final single-crystal high-nickel positive electrode materials obtained in Examples 1-10 and Comparative Examples 1-3 were subjected to button half-cell charge-discharge test. Specifically, the single-crystal high-nickel positive electrode material, polyvinylidene fluoride (PVDF) and superconducting carbon black (SP) conductive agent were mixed according to the ratio of 92:4:4, and N-methyl pyrrolidone (NMP) was added to adjust the solid content of the slurry to 50%, then the slurry was evenly coated on an aluminum foil and dried at 100°C for 12 hours to prepare a whole electrode sheet; then the whole electrode sheet was cut into three pieces for rolling, and the rolled three sheets were cut into circular electrode sheets with a diameter of 12 mm, and the cell was assembled in a glove box, and the negative electrode was a lithium electrode sheet. The test results are shown in Table 2.

Table 2

| | Charging capacity at 0.1C (mAh/g) | Discharge capacity at 0.1C (mAh/g) | Discharge capacity at 1C (mAh/g) | Initial Coulombic efficiency (%) | Retention rate after 50 cycles (%) |
|---|---|---|---|---|---|
| Example 1 | 229.1 | 208.5 | 190.5 | 91.0 | 97.3 |
| Example 2 | 228.2 | 207.4 | 189.2 | 90.9 | 96.9 |
| Example 3 | 227.4 | 206.1 | 188.2 | 90.6 | 96.2 |

(continued)

|  | Charging capacity at 0.1C (mAh/g) | Discharge capacity at 0.1C (mAh/g) | Discharge capacity at 1C (mAh/g) | Initial Coulombic efficiency (%) | Retention rate after 50 cycles (%) |
|---|---|---|---|---|---|
| Example 4 | 228.0 | 206.8 | 188.6 | 90.7 | 96.4 |
| Example 5 | 227.2 | 206.4 | 188.1 | 90.8 | 96.0 |
| Example 6 | 227.8 | 206.5 | 188.5 | 90.6 | 96.6 |
| Example 7 | 227.5 | 205.9 | 188.0 | 90.5 | 96.0 |
| Example 8 | 227.0 | 205.6 | 187.7 | 90.6 | 95.8 |
| Example 9 | 226.3 | 205.0 | 187.2 | 90.6 | 95.5 |
| Example 10 | 227.7 | 206.8 | 188.3 | 90.8 | 96.7 |
| Comparative Example 1 | 225.8 | 203.5 | 184.2 | 90.1 | 90.3 |
| Comparative Example 2 | 225.3 | 203.6 | 184.5 | 90.4 | 90.2 |
| Comparative Example 3 | 222.2 | 200.6 | 182 | 90.3 | 86.9 |

As can be seen from Table 2, for Examples 1-10, the 0.1C charging capacity of the cell prepared by the method in the present disclosure can reach more than or equal to 226.3 mAh/g, the 0.1 C discharging capacity can reach more than or equal to 205 mAh/g, the 1C discharging capacity can reach more than or equal to 187.2 mAh/g, the initial Coulombic efficiency can reach more than or equal to 90.5%, and the retention rate can reach more than or equal to 95.5% after 50 cycles.

From the comparison between Example 1 and Example 3-4, it can be seen that the sintering temperature in step (1) will affect the performance of the prepared single-crystal high-nickel positive electrode material, and the single-crystal high-nickel positive electrode material with better performance can be prepared by controlling the sintering temperature at 800-950°C, and the primary sintering temperature affects the size of single-crystal primary particles, with low temperature, the primary particles are small and the capacity is high, but the cycle performance is poor; with high temperature, the primary particles are large, the capacity is low, but the cycle performance is good. Based on the above, the primary sintering temperature range of 800-950°C is selected to obtain materials with good performance in all aspects. If the temperature is lower than 800°C, the single-crystal primary particles will grow too small, which will affect the cycle performance of materials. If the temperature is higher than 950°C, the single-crystal primary particles will grow too large, and although the cycle performance will be better, the capacity will decrease.

From the comparison between Example 1 and Examples 5-6, it can be seen that the sintering temperature in step (2) will affect the performance of the prepared single-crystal high-nickel positive electrode material, and the single-crystal high-nickel positive electrode material with better performance can be prepared by controlling the sintering temperature at 500-850°C. If the secondary sintering temperature is lower than 500°C, the coating layer may not be firmly combined with the primary sintering base material, resulting in the partial peeling of the coating during the cycling process, increasing the contact area between the electrolyte and the positive electrode material, increasing the side reactions, and resulting in gas generation of the battery and poor cycle performance. If the secondary sintering temperature is higher than 850°C, the primary particles will be hard agglomerates and caking, and difficult to be screened directly, requiring the crushing process to break the agglomerates; at the same time, the high temperature will also make the primary particle size larger and affect the material capacity.

From the comparison between Example 1 and Examples 7-10, it can be seen that the mass ratio of the primary sintered material, the titanium source and the cobalt source mentioned in step (2) will affect the performance of the prepared single-crystal high-nickel positive electrode material. Controlling the mass ratio of the primary sintered material, the titanium source and the cobalt source at 1:(0.001-0.006):(0.001-0.015) will produce the single-crystal high-nickel positive electrode material with better performance.

**Claims**

1. A preparation method of a single-crystal high-nickel positive electrode material, comprising the following steps:

   (1) mixing a precursor, a lithium source and a nano-oxide, and performing primary sintering treatment in an oxygen-containing atmosphere to obtain a primary sintered material; and
   (2) mixing the primary sintered material obtained in step (1) with a titanium source and a cobalt source, and performing secondary sintering treatment in an oxygen-containing atmosphere to obtain the single-crystal high-nickel positive electrode material;

   a mass ratio of the primary sintered material, the titanium source and the cobalt source in step (2) is 1:(0.001-0.006):(0.001-0.015).

2. The preparation method according to claim 1, wherein the precursor in step (1) comprises $Ni_xCo_yMn_z(OH)_2$, $x \geq 0.8$, $0.2 \geq y \geq 0$, $0.2 \geq z \geq 0$, and $x+y+z=1$.

3. The preparation method according to claim 1, wherein the nano-oxide in step (1) comprises any one or a combination of at least two of zirconium oxide, titanium oxide, tungsten oxide, molybdenum oxide, aluminum oxide or yttrium oxide.

4. The preparation method according to claim 1, wherein the nano-oxide accounts for 0.05%-0.3% of the single-crystal high-nickel positive electrode material by mass.

5. The preparation method according to claim 1, wherein a temperature of the primary sintering treatment in step (1) is 800-950°C and a time of the primary sintering treatment is 5-15 h.

6. The preparation method according to claim 1, wherein a temperature of the secondary sintering treatment in step (2) is 500-850°C and a time of the secondary sintering treatment is 4-20 h.

7. A single-crystal high-nickel positive electrode material, which is prepared by the preparation method according to any one of claims 1 to 6.

8. A positive electrode sheet, comprising the single-crystal high-nickel positive electrode material according to claim 7, and a specific surface area of the single-crystal high-nickel positive electrode material is 0.5-0.8 $m^2$/g;

   a pH of the single-crystal high-nickel positive electrode material is less than or equal to 11.8;
   a residual alkali of the single-crystal high-nickel positive electrode material is less than or equal to 3500 ppm.

9. A lithium-ion battery, comprising the positive electrode sheet according to claim 8.

FIG. 1

FIG. 2

## INTERNATIONAL SEARCH REPORT

| | International application No. |
|---|---|
| | **PCT/CN2021/130208** |

| A. | CLASSIFICATION OF SUBJECT MATTER |
|---|---|

H01M 4/505(2010.01)i; H01M 4/525(2010.01)i; H01M 10/0525(2010.01)i; C01G 53/00(2006.01)i; C30B 1/10(2006.01)i; C30B 29/22(2006.01)i

According to International Patent Classification (IPC) or to both national classification and IPC

| B. | FIELDS SEARCHED |
|---|---|

Minimum documentation searched (classification system followed by classification symbols)

H01M; C01G; C30B

Documentation searched other than minimum documentation to the extent that such documents are included in the fields searched

Electronic data base consulted during the international search (name of data base and, where practicable, search terms used)

CNTXT; CNABS; CNKI; WPABS; DWPI: 单晶, 高镍, 钛, 钴, 包覆, monocrystal+, single crystal+, high, Ni, nickel, titanium, Ti, cobalt, Co, coat+

| C. | DOCUMENTS CONSIDERED TO BE RELEVANT |
|---|---|

| Category* | Citation of document, with indication, where appropriate, of the relevant passages | Relevant to claim No. |
|---|---|---|
| PX | CN 112886006 A (SVOLT ENERGY TECHNOLOGY CO., LTD.) 01 June 2021 (2021-06-01) <br> claims 1-10 | 1-9 |
| Y | CN 110436531 A (ZHEJIANG MEIDU HAICHUANG LITHIUM BATTERY TECHNOLOGY CO., LTD.) 12 November 2019 (2019-11-12) <br> description, paragraphs 12-53 | 1-9 |
| Y | CN 106941162 A (SHANDONG YUHUANG NEW ENERGY TECHNOLOGY CO., LTD.) 11 July 2017 (2017-07-11) <br> description, paragraphs 6-32 | 1-9 |
| Y | CN 111463411 A (TIANJIN GUOAN MENGGULI NEW MATERIALS SCIENCE & TECHNOLOGY CO., LTD.) 28 July 2020 (2020-07-28) <br> description, paragraphs 5-91 | 1-9 |
| Y | CN 110451585 A (ZHEJIANG MEIDU HAICHUANG LITHIUM BATTERY TECHNOLOGY CO., LTD.) 15 November 2019 (2019-11-15) <br> description, paragraphs 6-69 | 1-9 |

☑ Further documents are listed in the continuation of Box C.    ☑ See patent family annex.

| | | |
|---|---|---|
| * | Special categories of cited documents: | "T" later document published after the international filing date or priority date and not in conflict with the application but cited to understand the principle or theory underlying the invention |
| "A" | document defining the general state of the art which is not considered to be of particular relevance | |
| "E" | earlier application or patent but published on or after the international filing date | "X" document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" | document referring to an oral disclosure, use, exhibition or other means | |
| "P" | document published prior to the international filing date but later than the priority date claimed | "&" document member of the same patent family |

| Date of the actual completion of the international search | Date of mailing of the international search report |
|---|---|
| **26 January 2022** | **17 February 2022** |

| Name and mailing address of the ISA/CN | Authorized officer |
|---|---|
| **China National Intellectual Property Administration (ISA/ CN)** <br> **No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

## INTERNATIONAL SEARCH REPORT

International application No.

**PCT/CN2021/130208**

### C.    DOCUMENTS CONSIDERED TO BE RELEVANT

| Category* | Citation of document, with indication, where appropriate, of the relevant passages | Relevant to claim No. |
|---|---|---|
| Y | CN 108023078 A (NINGBO RONBAY NEW ENERGY TECHNOLOGY CO., LTD.) 11 May 2018 (2018-05-11) description, paragraphs 4-70 | 1-9 |
| A | JP 2006054159 A (SUMITOMO METAL MINING CO., LTD.) 23 February 2006 (2006-02-23) entire document | 1-9 |

Form PCT/ISA/210 (second sheet) (January 2015)

**INTERNATIONAL SEARCH REPORT**
Information on patent family members

| International application No. |
| --- |
| **PCT/CN2021/130208** |

| Patent document cited in search report | | | Publication date (day/month/year) | Patent family member(s) | | | Publication date (day/month/year) |
| --- | --- | --- | --- | --- | --- | --- | --- |
| CN | 112886006 | A | 01 June 2021 | CN | 112886006 | | 06 August 2021 |
| CN | 110436531 | A | 12 November 2019 | | None | | |
| CN | 106941162 | A | 11 July 2017 | CN | 106941162 | B | 02 August 2019 |
| CN | 111463411 | A | 28 July 2020 | | None | | |
| CN | 110451585 | A | 15 November 2019 | | None | | |
| CN | 108023078 | A | 11 May 2018 | | None | | |
| JP | 2006054159 | A | 23 February 2006 | | None | | |

Form PCT/ISA/210 (patent family annex) (January 2015)